# EUROPÄISCHE PATENTSCHRIFT

(11) **EP 1 428 312 B1**
(45) Veröffentlichungstag und Bekanntmachung des Hinweises auf die Patenterteilung: **11.06.2008**
(21) Anmeldenummer: 01978159.0
(22) Anmeldetag: 19.09.2001
(51) Int. Cl.: H03D 3/00

(54) **MULTIBAND-EMPFÄNGER SOWIE ZUGEHÖRIGES VERFAHREN**
MULTIBAND RECEIVER AND METHOD ASSOCIATED THEREWITH
RECEPTEUR MULTIBANDE ET PROCEDE ASSOCIE

(43) Veröffentlichungstag der Anmeldung: 16.06.2004
(73) Patentinhaber: Siemens Home and Office Communications Devices GmbH & Co. KG, 81379 München (DE)
(72) Erfinder: VAN DER BURGT, Chiron, NL-7521 GK Enschede (NL)
(74) Vertreter: Maier, Daniel Oliver
(86) Internationale Anmeldenummer: PCT/DE2001/003610
(87) Internationale Veröffentlichungsnummer: WO 2003/028206

(56) Entgegenhaltungen:
- EP-A- 0 574 273
- WO-A-99/14863
- US-A- 5 661 761
- US-B1- 6 219 534
- J. CROLS : "A SINGLE CHIP 900 MHZ CMOS RECEIVER FRONT END WITHA HIGH PERFORMANCE LOW IF TOPOLOGY" IEEE JOURNAL OF SOLID STATE CIRCUITS, Bd. 30, Nr. 12, 1. Dezember 1995 (1995-12-01), Seiten 1483-1492, XP000557254 NEW YORK ,US.
- J. BORRALLO ET. AL: "SELF ADJUSTING DIGITAL IMAGE REJECTION RECEIVER FOR MOBILE COMMUNICATIONS" VEHICULAR TECHNOLOGY CONFERENCE 1997, 5. April 1997 (1997-04-05), Seiten 686-690, XP000736695 PHOENIX AR,US

## Beschreibung

Die vorliegende Erfindung bezieht sich auf einen Multiband-Empfänger sowie ein zugehöriges Verfahren und insbesondere auf einen Multiband-Empfänger zum gleichzeitigen Empfangen von Multiband-RF-Signalen mit zum Teil unterschiedlichen Trägerfrequenzen.

Der Einsatz von Telekommunikations-Netzwerken unter Verwendung von beispielsweise mobilen Funksystemen hat sich in den letzten Jahren verstärkt entwickelt, wobei es zu der Situation kommt, dass neben früheren Telekommunikations-Funknetzen oftmals neuartige z.B. zellular aufgebaute Netzwerke hinzukommen .

Folglich existieren zunehmend eine Vielzahl von unterschiedlichen Übertragungs-Standards gleichzeitig nebeneinander, wie beispielsweise digitale und analoge mobile Telekommunikations-Netzwerke. Bei den digitalen Telekommunikations-Netzwerken sind der GSM-Standard (Global System for Mobile Communication), der DECT-Standard (Digital Europeen Cordless Telecommunication) und der UMTS-Standard (Universal Mobile Telecommunication System) beispielhaft für Europa genannt. Weltweit sind ferner die PCS1900- (Personal Communication Services), DCS1800- (Digital Cellular System) oder JDC- (Japanese Digital Cellular) Standards beispielhaft erwähnt. Diese Vielzahl von unterschiedlichen Kommunikationsnetzen bzw. Übertragungsstandards basieren dabei auf im Wesentlichen gleichen oder unterschiedlichen Trägerfrequenzen.

Beispielsweise besteht die Notwendigkeit ein Notebook über eine "bluetooth°-Schnittstelle mit einem Handy und dieses über eine GSM-Schnittstelle mit dem Internet zu verbinden, wobei im Handy zwei unterschiedliche RF-Signale der unterschiedlichen Schnittstellen gleichzeitig zu empfangen sind.

Es entsteht daher zunehmend das Bedürfnis, einen Empfänger zu schaffen, der zumindest zwei oder mehrere Übertragungsstandards bzw. Frequenzbänder gleichzeitig realisiert. Telekommunikationsendgeräte mit derartigen Empfängern werden üblicherweise als sogenannte Dualband- oder Triple-Band-Endgeräte bezeichnet und ermöglichen den Empfang von RF-Signalen (Funkfrequenz-Signalen) in zwei oder drei Übertragungsstandards.

Zur Realisierung derartiger Multiband-Empfänger wurden üblicherweise zwei oder mehrere voneinander getrennte Funkempfänger (radio) miteinander kombiniert, wodurch sich jedoch außerordentlich hohe Kosten bei der Realisierung ergeben.

Ferner ist aus der Druckschrift EP 0 945 990 A1 ein Multiband-Empfänger zum Empfangen von Multiband-RF-Signalen mit zum Teil unterschiedlichen Trägerfrequenzen bekannt, wobei ein RF/IF-Wandler die RF-Signale (Radio Frequency, Funkfrequenz) in sogenannte Zwischenfrequenz-Signale (Intermediate Frequency) umwandelt. Genauer gesagt werden hierbei unter Verwendung eines lokalen Oszillators zwei Zwischenfrequenzen (Intermediate Frequencies) für beispielsweise die unterschiedlichen Standards GSM1800 und GSM1900 erzeugt und somit ein Dualband-Empfänger realisiert. Nachteilig ist hierbei jedoch die Beschränkung auf relativ wenige Trägerfrequenzen bzw. auf Trägerfrequenzen in einem ähnlichen Frequenzbereich und die Verwendung von teueren Zwischenfrequenzpfaden.

Weitere Multiband-Empfänger sind aus J. BORRALLO ET. AL: "SELF ADJUSTING DIGITAL IMAGE REJECTION RECEIVER FOR MOBILE COMMUNICATIONS" VEHICULAR TECHNOLOGY CONFERENCE 1997, 5. April 1997 (1997-04-05), Seiten 686-690, XP000736695 PHOENIX AR,US oder WO 99/14863 A bekannt. Ferner offenbart J. CROLS: "A SINGLE CHIP 900 MHZ CMOS RECEIVER FRONT END WITH A HIGH PERFORMANCE LOW IF TOPOLOGY" IEEE JOURNAL OF SOLID STATE CIRCUITS, Bd. 30, Nr. 12, 1. Dezember 1995 (1995-12-01), Seiten 1483-1492, XP000557254 NEW YORK, US einen RF Empfänger mit In-Phase- und Quadratur-Mischer im IF Bereich und einem komplexen Filter im IF Bereich zur Unterdrückung von gespiegelten IF Signalen.

Demgegenüber liegt der Erfindung die Aufgabe zugrunde, einen Multiband-Empfänger sowie ein zugehöriges Verfahren zu schaffen, mit dem Multiband-RF-Signale mit zum Teil stark unterschiedlichen Trägerfrequenzen auf kostengünstige und flexibel einstellbare Art und Weise gleichzeitig empfangen werden können.

Erfindungsgemäß wird diese Aufgabe hinsichtlich des Empfängers durch die Merkmale des Patentanspruchs 1 und hinsichtlich des Verfahrens durch die Maßnahmen des Patentanspruchs 15 gelöst.

Insbesondere durch die Verwendung eines RF/IF-Wandlers zum Umwandeln der RF-Signale in eine Vielzahl von Zwischenfrequenz-Signalen, wobei eine der Vielzahl von RF-Signalen entsprechende Vielzahl von lokalen Oszillatoren zum Erzeugen von den Trägerfrequenzen zugehörigen In-Phase- und Quadratur-Komponenten eingesetzt werden, sowie aufgrund der Verwendung eines In-Phase- und Quadratur-Mixers zum Mischen der jeweiligen In-Phase- und Quadratur-Komponenten mit den RF-Signalen zum Erzeugen von IF-In-Phase- und IF-Quadratur-Komponenten in einem Zwischenfrequenzbereich, können unter Verwendung eines zusätzlichen komplexen Filters auf der Grundlage der Zwischenfrequenz-Signale die für die weitere Verarbeitung gewünschten Zwischenfrequenz-Signale auf einfache und sehr genaue Art und Weise ausgefiltert werden. Somit kann nicht nur ein einziger Funkempfänger für eine Vielzahl von Multiband-Funkfrequenzen bzw. RF-Signalen gleichzeitig verwendet werden, sondern es ergibt sich darüber hinaus eine äußerst flexible Konfiguration zur Realisierung von bisher nur sehr schwer oder nicht vereinbarer Übertragungsstandards.

Vorzugsweise weisen die Zwischenfrequenz-Signale ungespiegelte und gespiegelte Signale in einem niederen Zwischenfrequenzbereich (Low IF) auf, wobei das komplexe Filter eine Phasenverschiebung zwischen den zugehörigen In-Phase- und Quadratur-Komponenten diese Signale derart durchführt, dass sich die unerwünschten gespiegelten Signalkomponenten zumindest teilweise auslöschen. Die Verwendung von Signalen in einem niederen Zwischenfrequenzbereich ermöglicht die Realisierung von besonders kostengünstigen Multiband-Empfängern. Die komplexe Filterung kann hierbei analog oder digital an Hand von analogen oder digitalen Zwischenfrequenz-Signalen durchgeführt werden. Wenn sich die gespiegelten oder ungespiegelten Signale jeweils alle im gleichen positiven oder negativen Frequenzbereich befinden, kann das komplexe Filter besonders einfach realisiert werden.

Vorzugsweise erzeugen die lokalen Oszillatoren LO-Signale, die zueinander keinerlei Interferenzen aufweisen, wodurch sich die Signalqualität wesentlich verbessern lässt. Als komplexes Filter wird beispielsweise ein Polyphase-Filter verwendet.

Zur weiteren Verbesserung der Empfangsqualität kann der Multiband-Empfänger einen Vorverstärker in seinem RF-Empfangsteil aufweisen, der einen Frequenzsplitter zum Aufteilen der RF-Signale in ihre zugehörigen Trägerfrequenzbereiche, getrennte Verstärkerpfade zum Verstärken der RF-Signale in den jeweiligen Trägerfrequenzbereichen, und einen Signalkombinierer zum Zusammenfügen der aufgeteilten und verstärkten RF-Signale aufweist. Insbesondere wenn die Verstärkerpfade jeweils ein RF-Bandpass-Filter und einen variablen RF-Verstärker aufweisen, kann für jeden Trägerfrequenzbereich eine sogenannte Low Noise-Vorverstärkung durchgeführt werden.

Ferner kann zur Verbesserung einer Empfangsqualität in einem Zwischenfrequenz-Empfangsteil ein Verstärkerpfad mit einem variablen IF-Verstärker und einem IF-Tiefpassfilter verwendet werden.

Vorzugsweise befindet sich in einer ausgangsseitig angeordneten digitalen Signalverarbeitung eine Vielzahl von lokalen Oszillatoren zum Erzeugen von den ermittelten Zwischenfrequenz-Signalen zugehörigen Signalkomponenten und einer Vielzahl von digitalen Tiefpassfiltern zum Filtern der digitalen Signalkomponenten. Auf diese Weise werden die im niederen Zwischenfrequenzbereich liegenden Zwischenfrequenz-Signale qualitativ hochwertig weiterverarbeitet.

In den weiteren Unteransprüchen sind weitere vorteilhafte Ausgestaltungen der Erfindung gekennzeichnet.

Die Erfindung wird nachstehend an Hand von Ausführungsbeispielen unter Bezugnahme auf die Zeichnung beschrieben.

Es zeigen:
- Figur 1: eine vereinfachte Blockdarstellung eines Multiband-Empfängers gemäß einem ersten Ausführungsbeispiel;
- Figur 2: eine vereinfachte Blockdarstellung eines Multiband-Empfängers gemäß einem zweiten Ausführungsbeispiel;
- Figur 3: eine vereinfachte spektrale Darstellung der gemäß dem ersten Ausführungsbeispiel verwendeten Signale;
- Figur 4: eine vereinfachte spektrale Darstellung der gemäß dem zweiten Ausführungsbeispiel verwendeten Signale; und
- Figur 5: eine vereinfachte spektrale Darstellung von Signalen gemäß einem weiteren nicht dargestellten Ausführungsbeispiel.

Die Erfindung wird nachstehend beispielhaft an Hand eines Dualband-Empfängers beschrieben, der RF-Signale mit Trägerfrequenzen in einem 1800 MHz und einem 900 MHz Band empfängt. Die angegebenen Frequenzen dienen hierbei lediglich zur Verdeutlichung des grundsätzlichen Prinzips.

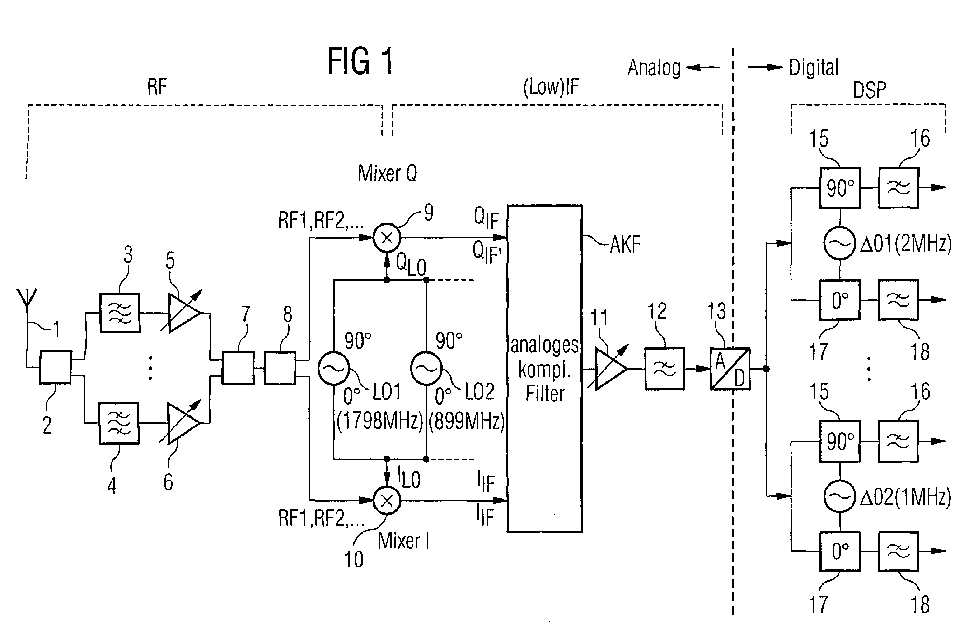

Figur 1 zeigt eine vereinfachte Blockdarstellung eines Multiband-Empfängers zum Empfangen von zwei RF-Signalen, die in einem Trägerfrequenzbereich von 1800 MHz und 900 MHz übertragen werden. Ein RF-Empfangsteil RF (Radio Frequency, Funkfrequenz) dient im Wesentlichen dem Empfang der RF-Signale mittels beispielsweise einer Antenne 1 und einer Vorverarbeitung durch einen aus den Blöcken 2 bis 7 bestehenden Vorverstärker. Die Antenne 1 kann jedoch in gleicher Weise durch einen Koaxialkabel-Anschluss oder sonstigen Anschluss zum drahtgebundenen Empfang der RF-Signale ersetzt werden. Der Vorverstärker dient im Wesentlichen einer sogenannten Low Noise-Verstärkung und kann grundsätzlich auch entfallen.

Gemäß Figur 1 wird das zumindest zwei RF-Signale aufweisende und an der Antenne 1 empfangene Eingangssignal in einem Frequenzsplitter 2 in RF-Signale mit ihren zugehörigen Trägerfrequenzbereichen aufgeteilt. Genauer gesagt wird hierbei ein beispielsweise bei der Trägerfrequenz von 1800 MHz übertragenes RF-Signal RF1 in einen aus den Blöcken 3 und 5 bestehenden ersten Verstärkerpfad und ein bei der Trägerfrequenz von 900 MHz übertragenes RF-Signal RF2 in den aus den Blöcken 4 und 6 bestehenden Verstärkerpfad geleitet. Hierbei erfolgt in den Blöcken 3 und 4 eine RF-Bandpass-Filterung zur Verbesserung der jeweiligen RF-Signale RF1 und RF2. Anschließend erfolgt eine getrennte Verstärkung in den RF-Verstärkern 5 und 6, wobei in einem Signalkombinierer 7 anschließend die aufgeteilten, gefilterten und verstärkten RF-Signale RF1 und RF2 wieder zusammengeführt werden.

In einem Signalsplitter 8 werden anschließend die so verarbeiteten RF-Signale RF1, RF2 nunmehr leistungsmäßig beispielsweise gleich aufgeteilt und einem Quadratur-Mixer 9 bzw. einem In-Phase-Mixer 10 als Eingangssignale zugeführt. Ferner wird dem Quadratur-Mixer 9 und dem In-Phase-Mixer 10 eine jeweilige Quadratur-Komponente Q_{LO} und In-Phase-Komponente I_{LO} zugeführt, die aus einer der Vielzahl von RF-Signalen entsprechenden Vielzahl von lokalen Oszillatoren LO1, LO2, ... erzeugt werden. Da gemäß Figur 1 lediglich zwei RF-Signale RF1 und RF2 mit Trägerfrequenzen von 1800 MHz und 900 MHz verwendet werden, werden erfindungsgemäß genau zwei lokale Oszillatoren LO1 und LO2 verwendet, die bei einer knapp unterhalb oder knapp oberhalb der jeweiligen Trägerfrequenz liegenden Frequenz oszillieren und jeweilige In-Phase- und Quadratur-Komponenten erzeugen. Beispielsweise weist der lokale Oszillator LO1 eine Frequenz von 1798 MHz auf und liegt damit 2 MHz unterhalb der Trägerfrequenz des RF-Signals RF1. Andererseits oszilliert der zweite lokale Oszillator LO2 bei einer Frequenz von 899 MHz und liegt somit 1 MHz unterhalb der Trägerfrequenz des zweiten RF-Signals RF2. Vorzugsweise liegen die gewählten Frequenzdifferenzen (2MHz, 1Mhz) in einem ähnlichen Frequenzbereich. Grundsätzlich können die Trägerfrequenzen natürlich auch in einem ähnlichen (oder identischen) Frequenzbereich liegen (z.B. GSM 1800, GSM 1900, DECT), wodurch sich geringere Probleme bei der Realisierung des Multiband-Empfängers ergeben.

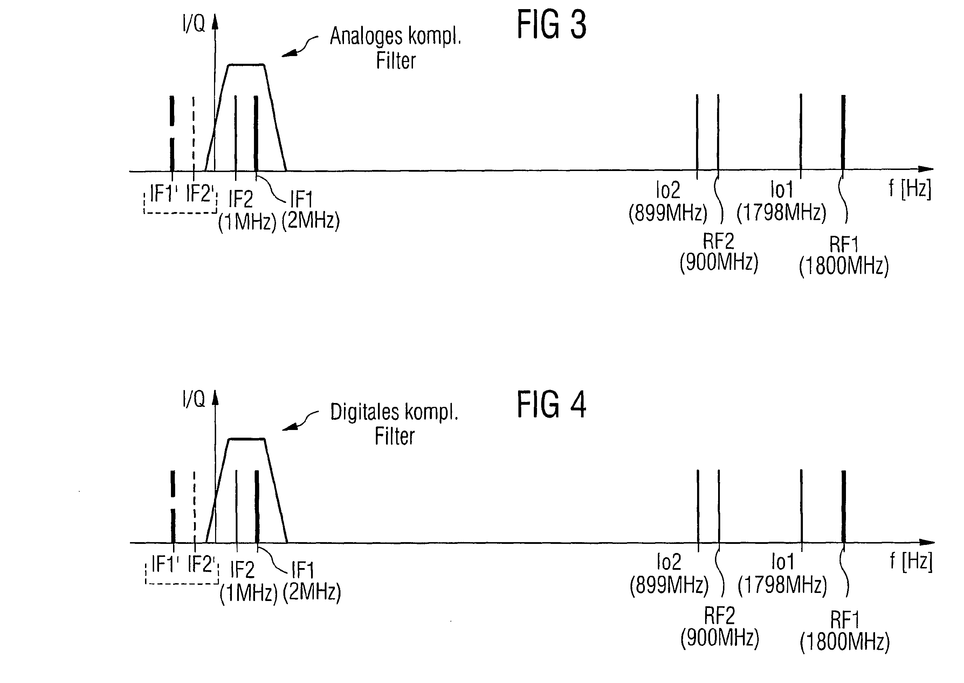

Figur 3 zeigt eine vereinfachte spektrale Darstellung der in Figur 1 verwendeten Signale. Bei dieser stark vereinfachten Darstellung besteht das RF-Signal RF1 aus einer Spektrallinie bei 1800 MHz und das RF-Signal RF2 aus einer Spektrallinie bei 900 MHz. Die von den lokalen Oszillatoren LO1 und LO2 erzeugten lokalen Frequenzsignale bzw. LO-Signale lo1 und lo2 liegen demzufolge als Spektrallinien bei um unterschiedliche Frequenzdifferenzen 2MHz und 1Mhz verschobenen Frequenzen 1798 MHZ und 899 MHz. In Figur 3 sind hierbei sowohl die In-Phase-Komponenten I_{LO} als auch die um 90° verschobenen Quadratur-Komponenten Q_{LO} identisch dargestellt, wenngleich sie den unterschiedlichen Mixern bzw. dem Quadratur-Mixer 9 und dem In-Phase-Mixer 10 zugeführt werden.

Die Kombination der Mixer 9 und 10 sowie der zugehörigen lokalen Oszillatoren LO1, LO2, ... ergibt einen sogenannten RF/IF-Wandler zum Umwandeln der Vielzahl von RF-Signalen RF1, RF2, ... in eine Vielzahl von analogen Zwischenfrequenz-Signalen IF1, IF2 sowie ihren zugehörigen gespiegelten Signalen IF1' und IF2'. Genauer gesagt werden gemäß Figur 1 vom Quadratur-Mixer 9 die jeweiligen Quadratur-Komponenten der ungespiegelten Zwischenfrequenz-Signale IF1 und IF2 sowie der gespiegelten Zwischenfrequenz-Signale IF1' und IF2' ausgegeben. In gleicher Weise werden vom In-Phase-Mixer 10 die In-Phase-Komponenten der ungespiegelten und gespiegelten Zwischenfrequenz-Signale IF1, IF2 und IF1' und IF2' ausgegeben.

Die spektrale Position dieser ungespiegelten und gespiegelten Zwischenfrequenz-Signale IF1, IF2, IF1' und IF2' ist in Figur 3 dargestellt, wobei aufgrund der Faltung mit den lokalen Oszillatorsignalen lol und 102 die den RF-Signalen RF1 und RF2 entsprechenden Zwischenfrequenz-Signale IF1 und IF2 in einem niederen Zwischenfrequenzbereich bei den Frequenzen von 2 MHz und 1 MHz zum Liegen kommen. Hierbei spricht man von Signalen im niederen Zwischenfrequenzbereich, wenn deren Frequenz im wesentlichen einer Bandbreite der zugehörigen RF-Signale entspricht. Bei Realisierung eines RF/IF-Wandlers für einen derartigen niederen Zwischenfrequenzbereich ergeben sich besonders kostengünstige Realisierungen für die Zwischenfrequenzpfade.

Unter Verwendung eines nachgeschalteten analogen komplexen Filters AKF können nunmehr die gespiegelten Zwischenfrequenz-Signale IF1' und IF2' ausgeblendet werden, was in Figur 3 durch die Bandpassfilterung von ca. 0 bis 3 MHz angedeutet ist. Beispielsweise kann die analoge komplexe Filterung durch eine geeignete Phasenverschiebung der vom RF/IF-Wandler erzeugten In-Phase- und Quadratur-Komponenten I_{IF}, I_{IF'}, Q_{IF}, Q_{IF'} im Zwischenfrequenzbereich herbeigeführt werden, wodurch es zu einem zumindest teilweisen Auslöschen der gespiegelten Zwischenfrequenz-Signale IF1' und IF2' kommt.

Gemäß Figur 3 sind die Frequenzen der lokalen Oszillatoren LO1 und LO2 bzw. der dazugehörigen Signale 101 und 102 derart zu wählen, dass sich insbesondere bei einer Faltung im Frequenzbereich keine Interferenzen ergeben. Auf diese Weise können auch RF-Signale mit weit voneinander getrennten Trägerfrequenzen in einen niederfrequenten Zwischenfrequenzbereich (LOW IF) gebracht werden, der eine einfache und kostengünstige Signalverarbeitung ermöglicht. In gleicher Weise ist aus Figur 3 ersichtlich, dass die von den lokalen Oszillatoren LO1 und LO2 erzeugten Signale lo1 und lo2 vorzugsweise jeweils unterhalb oder oberhalb ihrer zugehörigen RF-Signale liegen sollten, damit auch die zugehörigen Zwischenfrequenz-Signale IF1 und IF2 jeweils im gleichen positiven oder negativen Frequenzbereich zu liegen kommen. Auf diese Weise können die unerwünschten gespiegelten Zwischenfrequenz-Signale IF1' und IF2' zuverlässig unterdrückt werden. Zur Realisierung des analogen komplexen Filters AKF wird vorzugsweise ein sogenanntes Polyphase-Filter verwendet.

Mit dem vorstehend beschriebenen RF/IF-Umwandler werden somit eine Vielzahl von RF-Signalen mit einem Frequenzabstand Δf, der wesentlich größer ist als eine zugehörige Zwischenfrequenz-Bandbreite, in nahezu den gleichen Zwischenfrequenzbereich übergeführt, wobei insbesondere bei einem niederfrequenten Zwischenfrequenzbereich die Situation auftritt, dass positive und negative Frequenzbänder um den Nullpunkt liegen. Unter Verwendung der In-Phase- und Quadratur-Komponenten dieser Zwischenfrequenz-Signale kann anschließend mittels eines komplexen analogen "Image-Rejection"-Filters (Image = gespiegelte Signale) ein leicht weiterverarbeitbares Signal erzeugt werden. Derartige niederfrequente Zwischenfrequenz-Signale ermöglichen darüber hinaus die Integration des Filters in einem RF-Chip, wodurch sich die Kosten und der Platzbedarf weiter verringern. Ferner ermöglicht der Einsatz des analogen komplexen Filters AKF die Beseitigung von störenden Gleichspannungskomponenten (DC).

Ausgangsseitig des analogen komplexen Filters AKF erhält man nunmehr ein Datensignal im niederen Zwischenfrequenzbereich, welches optional einem variablen IF-Verstärker 11 und einem IF-Tiefpassfilter 12 zugeführt werden kann. Anschließend wird das bislang noch analoge Zwischenfrequenz-Signal von einem A/D-Wandler 13 in ein digitales Zwischenfrequenz-Signal umgewandelt und von einem digitalen Signalverarbeitungsteil DSP zur Erzeugung von rückgewonnenen Datensignalen weiterverarbeitet.

Bei dieser an sich bekannten digitalen Weiterverarbeitung kann beispielsweise für jede in einem Zwischenfrequenz- bzw. IF-Empfangsteil IF erzeugte Zwischenfrequenz ein lokaler Oszillator zum Erzeugen von den Zwischenfrequenz-Signalen IF1, IF2 zugehörigen Signalkomponenten eingesetzt werden. Beispielsweise kann gemäß Figur 1 ein lokaler Oszillator ΔO1 bei der zum Zwischenfrequenz-Signal IF1 liegenden Frequenz von 2 MHz schwingen und über einen Mischer 15 bzw. 17 jeweils mit seiner In-Phase- und Quadratur-Komponente zum digitalen Eingangssignal gemischt werden. Die so gemischten Signale können anschließend in digitalen Tiefpass-Filtern 16 und 18 weiterverarbeitet werden, wodurch sich eine Signalqualität weiter verbessern lässt. In gleicher Weise wird diese digitale Signalverarbeitung mittels eines zweiten lokalen Oszillators ΔO2 auf das zweite Zwischenfrequenz-Signal IF2 bei einer Frequenz von ca. 1 MHz angewendet.

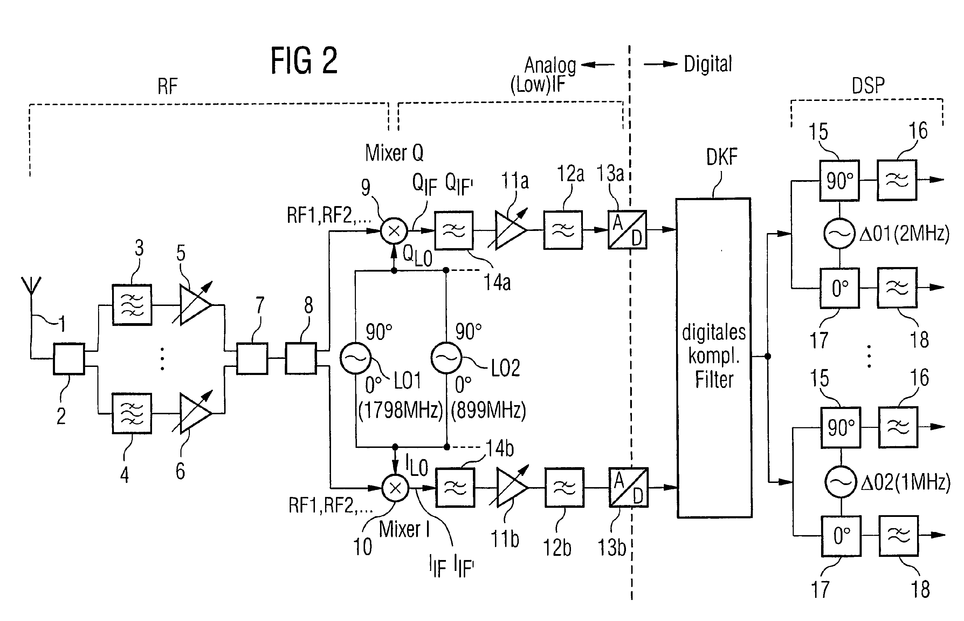

Figur 2 zeigt eine vereinfachte Blockdarstellung eines Multiband-Empfängers gemäß einem zweiten Ausführungsbeispiel, wobei gleiche Bezugszeichen gleiche oder entsprechende Elemente bezeichnen und auf eine wiederholte Beschreibung nachfolgend verzichtet wird.

Gemäß Figur 2 wird im Gegensatz zum Ausführungsbeispiel gemäß Figur 1 nunmehr ein digitales komplexes Filter DKF zur Reduzierung der gespiegelten Zwischenfrequenz-Signale IF1' und IF2 verwendet. Figur 4 zeigt hierbei die zum zweiten Ausführungsbeispiel gemäß Figur 2 gehörenden Signale in einer vereinfachten spektralen Darstellung, wobei keine Unterschiede zur vereinfachten Darstellung gemäß Figur 3 vorliegen. Auf eine wiederholte Beschreibung von Figur 4 wird daher unter Verweis auf die Beschreibung in Figur 3 nachfolgend verzichtet.

Der wesentliche Unterschied zwischen dem ersten Ausführungsbeispiel gemäß Figur 1 und dem zweiten Ausführungsbeispiel gemäß Figur 2 besteht lediglich darin, dass das komplexe Filter nunmehr als digitales komplexes Filter DKF ausgestaltet ist und sich im digitalen Teil des Multiband-Empfängers befindet. Gemäß Figur 2 werden demzufolge die vom Quadratur-Mixer 9 und vom In-Phase-Mixer 10 ausgegebenen Quadratur- und In-Phasen-Komponenten I_{IF}, I_{IF'}, Q_{IF}, Q_{IF'} der Zwischenfrequenz-Signale IF1, IF2, ... IF1', IF2', ... beispielsweise einem IF-Tiefpassfilter 14a und 14b zugeführt und anschließend an einen aus Figur 1 bekannten IF-Verstärkerpfad weitergegeben.

Da jedoch das komplexe Filter erst im digitalen Teil realisiert ist, muss der IF-Verstärkerpfad sowohl für die Quadratur-Komponenten als auch für die In-Phase-Komponenten, d.h. also doppelt, ausgebildet sein und besteht beispielsweise wiederum aus einem variablen IF-Verstärker 11a 11b und einem IF-Tiefpassfilter 12a und 12b. Ebenso müssen nunmehr für die Quadratur-Komponenten und die In-Phase-Komponenten jeweils ein A/D-Wandler 13a und 13b realisiert werden, um anschließend das digitalisierte Zwischenfrequenz-Signal bzw. deren Komponenten dem digitalen komplexen Filter in bekannter Weise zur Filterung der gespiegelten Zwischenfrequenz-Signale IF1' und IF2' zuzuführen. Die Filterung entspricht hierbei wiederum im Wesentlichen der Filterung des analogen komplexen Filters, weshalb an dieser Stelle auf die Beschreibung gemäß Figur 1 verwiesen wird.

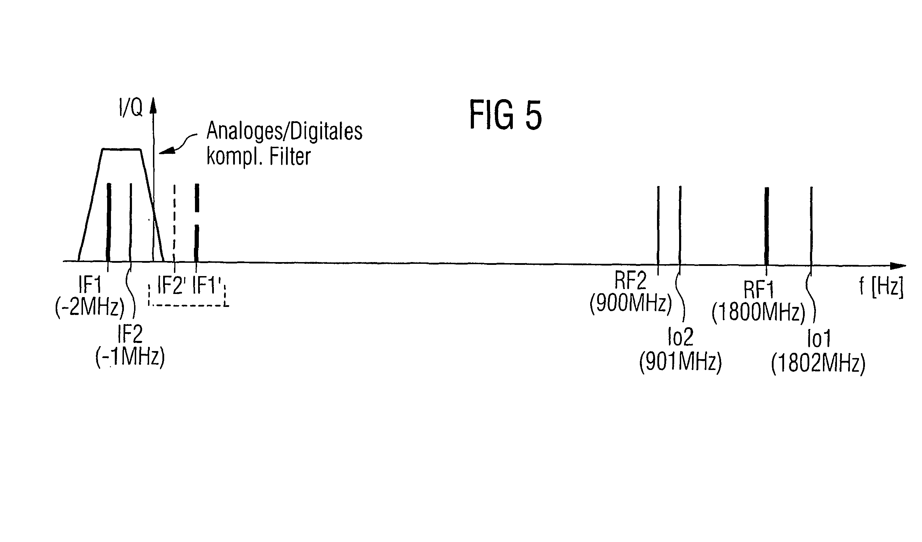

Figur 5 zeigt eine vereinfachte spektrale Darstellung von Signalen gemäß einem weiteren nicht dargestellten Ausführungsbeispiel, wobei gleiche Bezugszeichen gleiche oder entsprechende Signallinien bezeichnen und auf eine wiederholte Beschreibung nachfolgend verzichtet wird.

Gemäß Figur 5 befinden sich im Gegensatz zu den Spektrallinien der Figuren 3 und 4 nunmehr die von den lokalen Oszillatoren erzeugten Signale 101 und 102 oberhalb der zugehörigen RF-Trägerfrequenzen RF1 und RF2. Genauer gesagt liegt das vom lokalen Oszillator LO1 erzeugte Signal lol bei 1802 MHz und das Signal 102 bei 901 MHz. Folglich liegen nunmehr die bei der Faltung entstehenden Zwischenfrequenz-Signale IF1 und IF2 im negativen Frequenzbereich bei -2 MHz und -1 MHz, während die zugehörigen gespiegelten Zwischenfrequenz-Signale IF1' und IF2' bei den Frequenzen +2 MHZ und +1 MHz liegen. Bei einem derartigen Ausführungsbeispiel muss daher das analoge oder digitale komplexe Filter derart eingestellt werden, dass nunmehr der negative Frequenzbereich rückgewonnen wird und die im positiven Bereich liegenden gespiegelten Zwischenfrequenz-Signale zumindest teilweise ausgelöscht werden. Die weitere Signalverarbeitung ist wiederum vergleichbar zu den vorstehend beschriebenen Ausführungsbeispielen.

Die Erfindung wurde vorstehend an Hand eines Dualband-Telekommunikationsendgerätes für Trägerfrequenzen von 1800 MHz und 900 MHz beschrieben. Sie ist jedoch nicht darauf beschränkt und bezieht sich vielmehr auf alle weiteren Multiband-Empfänger, mit denen RF-Signale mit zum Teil unterschiedlichen Frequenzen drahtlos oder drahtgebunden empfangen werden. Insbesondere können derartige Multiband-Empfänger in sogenannten mobilen Telekommunikationsendgeräten, sogenannten "Software Defined Radios" und TD-SCDMA-Produkten verwendet werden.

## Patentansprüche

1. Multiband-Empfänger zum gleichzeitigen Empfangen einer Vielzahl von RF-Signalen mit unterschiedlichen Trägerfrequenzen mit:
einem RF-Empfangsteil (RF) zum Verarbeiten der RF-Signale (RF1, RF2, ...);
einem RF/IF-Wandler zum Umwandeln der Vielzahl von RF-Signalen (RF1, RF2, ...) in eine Vielzahl von analogen Zwischenfrequenz-Signalen (IF1, IF2);
einem IF-Empfangsteil (IF) zum Verarbeiten der Zwischenfrequenz-Signale;
einem A/D-Wandler (13; 13a, 13b) zum Umwandeln der analogen Zwischenfrequenz-Signale in digitale Zwischenfrequenz-Signale; und
einem digitalen Signalverarbeitungsteil (DSP) zur digitalen Signalverarbeitung der digitalen Zwischenfrequenz-Signale und zur Erzeugung von rückgewonnenen Datensignalen,
**dadurch gekennzeichnet, dass**
der RF/IF-Wandler eine der Vielzahl von RF-Signalen (RF1, RF2, ...) entsprechende Vielzahl von lokalen Oszillatoren (LO1, LO2, ...) zum Erzeugen von den Trägerfrequenzen zugehörigen LO-Signalen (LO1, LO2, ...) mit LO-In-Phase-Komponenten (I_{LO}) und LO-Quadratur-Komponenten (Q_{LO}) sowie einen der Vielzahl von RF-Signalen gemeinsamen In-Phase-Mixer (10) und einen der Vielzahl von RF-Signalen gemeinsamen Quadratur-Mixer (9) zum Mischen der jeweiligen LO-In-Phase- und Quadratur-Komponenten (I_{LO}, Q_{LO}) die aus der Vielzahl von lokalen Oszillatoren (LO1, LO2, ...) erzeugt werden, mit den RF-Signalen (RF1, RF2, ...) zum Erzeugen der Zwischenfrequenz-Signale (IF1, IF2, IF1', IF2') mit IF-In-Phase-Komponenten (I_{IF}, I_{IF'}) und IF-Quadratur-Komponenten (Q_{IF}, Q_{IF'}) in einem Zwischenfrequenzbereich aufweist, wobei
ein komplexes Filter (AKF; DFK) eine komplexe Filterung auf der Grundlage der Zwischenfrequenz-Signale (IF1, IF2, IF1', IF2') zur Unterdrückung von gespiegelten Zwischenfrequenz-Signalen durchführt.

2. Multiband-Empfänger nach Patentanspruch 1, **dadurch gekennzeichnet, dass** die Zwischenfrequenz-Signale (IF1, IF2 und IF1', IF2') in einem niederen Zwischenfrequenzbereich liegen und das komplexe Filter (AKF; DKF) eine Phasenverschiebung der zugehörigen IF-In-Phase-Komponenten (I_{IF}, I_{IF'}) und IF-Quadratur-Komponenten (Q_{IF}, Q_{IF'}) zum zumindest teilweisen Auslöschen der gespiegelten Zwischenfrequenz-Signale (IF1' , IF2') durchführt.

3. Multiband-Empfänger nach Patentanspruch 1 oder 2, **dadurch gekennzeichnet, dass** die Zwischenfrequenz-Signale (IF1, IF2, IF1', IF2') analoge Signale darstellen und das komplexe Filter ein analoges komplexes Filter ist.

4. Multiband-Empfänger nach Patentanspruch 1 oder 2, **dadurch gekennzeichnet, dass** die Zwischenfrequenz-Signale (IF1, IF2, IF1', IF2') digitale Signale darstellen und das komplexe Filter ein digitales komplexes Filter ist.

5. Multiband-Empfänger nach einem der Patentansprüche 2 bis 4, **dadurch gekennzeichnet, dass** die gespiegelten Zwischenfrequenz-Signale (IF1', IF2') alle im gleichen positiven oder negativen Frequenzbereich liegen.

6. Multiband-Empfänger nach einem der Patentansprüche 1 bis 5, **dadurch gekennzeichnet, dass** die Vielzahl von lokalen Oszillatoren (LO1, LO2, ...) LO-Signale (101, 102, ...) erzeugen, die keine Interferenzen zueinander aufweisen.

7. Multiband-Empfänger nach einem der Patentansprüche 1 bis 6, **dadurch gekennzeichnet, dass** das komplexe Filter (AKF; DKF) einen Polyphase-Filter aufweist.

8. Multiband-Empfänger nach einem der Patentansprüche 1 bis 7, **dadurch gekennzeichnet, dass** das RF-Empfangsteil (RF) eine Antenne (1) und einen Vorverstärker aufweist.

9. Multiband-Empfänger nach Patentanspruch 8, **dadurch gekennzeichnet, dass** der Vorverstärker einen Frequenzsplitter (2) zum Aufteilen der RF-Signale in ihre zugehörigen Trägerfrequenzbereiche,
eine Vielzahl von getrennten Verstärkerpfaden zum Verstärken der RF-Signale in den zugehörigen Trägerfrequenzbereichen, und
einen Signalkombinierer (7) zum Zusammenführen der aufgeteilten und verstärkten RF-Signale aufweist.

10. Multiband-Empfänger nach Patentanspruch 9, **dadurch gekennzeichnet, dass** die Verstärkerpfade jeweils ein RF-Bandpass-Filter (3, 4) und einen variablen RF-Verstärker (5, 6) aufweisen.

11. Multiband-Empfänger nach einem der Patentansprüche 1 bis 10, **dadurch gekennzeichnet, dass** das RF-Empfangsteil einen Signalsplitter (8) zum leistungsmäßigen Aufteilen der RF-Signale aufweist.

12. Multiband-Empfänger nach einem der Patentansprüche 1 bis 11, **dadurch gekennzeichnet, dass** das IF-Empfangsteil zumindest einen IF-Verstärkerpfad aufweist.

13. Multiband-Empfänger nach Patentanspruch 12, **dadurch gekennzeichnet, dass** der IF-Verstärkerpfad einen variablen IF-Verstärker (11; 11a, 11b) und ein IF-TiefpassFilter (12; 12a, 12b) aufweist.

14. Multiband-Empfänger nach einem der Patentansprüche 1 bis 13, **dadurch gekennzeichnet, dass** das digitale Signalverarbeitungsteil (DSP) eine Vielzahl von lokalen Oszillatoren (ΔO1, ΔO2, ...) zum Erzeugen von den Zwischenfrequenz-Signalen (IF1, IF2, ...) zugehörigen digitalen Signalkomponenten, und
eine Vielzahl von digitalen Tiefpass-Filtern (16, 18) zum Filtern der digitalen Signalkomponenten aufweist.

15. Verfahren zum gleichzeitigen Empfangen einer Vielzahl von RF-Signalen mit unterschiedlichen Trägerfrequenzen mit den Schritten:
Realisierung eines RF-Empfangs zum Verarbeiten der RF-Signale (RF1, RF2, ...);
Durchführen einer RF/IF-Wandlung zum Umwandeln der Vielzahl von RF-Signalen (RF1, RF2, ...) in eine Vielzahl von analogen Zwischenfrequenz-Signalen (IF1, IF2, ...);
Realisierung eines IF-Empfangs zum Verarbeiten der Zwischenfrequenz-Signale (IF1, IF2, ...);
Durchführen einer A/D-Wandlung zum Umwandeln der analogen Zwischenfrequenz-Signale in digitale Zwischenfrequenz-Signale; und
Durchführen einer digitalen Signalverarbeitung der digitalen Zwischenfrequenz-Signale und Erzeugen von rückgewonnenen Datensignalen, **dadurch gekennzeichnet, dass** bei der RF/IF-Wandlung eine der Vielzahl von RF-Signalen (RF1, RF2, ...) entsprechende Vielzahl von den Trägerfrequenzen zugehörigen LO-Signalen (101, 102, ...) mit LO-In-Phase-Komponenten (I_{LO}) und LO-Quadratur-Komponenten (Q_{LO}) erzeugt werden und die LO-In-Phase- und Quadratur-Komponenten (I_{LO}, Q_{LO}) mit den RF-Signalen (RF1, RF2, ...) zum Erzeugen der Zwischenfrequenz-Signale (IF1, IF2, IF1', IF2') mit jeweiligen IF-In-Phase-Komponenten (I_{IF}, IF_{IF'}) und IF-Quadratur-Komponenten (Q_{IF}, Q_{IF'}) für die Vielzahl von RF-Signalen (RF1, RF2, ...) gemeinsam in einen Zwischenfrequenzbereich gemischt werden, wobei ferner eine komplexe Filterung auf der Grundlage der Zwischenfrequenz-Signale (IF1, IF2, IF1', IF2') zur Unterdrückung von gespiegelten Zwischenfrequenz-Signalen durchgeführt wird.

16. Verfahren nach Patentanspruch 15, **dadurch gekennzeichnet, dass** bei der RF/IF-Wandlung Zwischenfrequenz-Signale (IF1, IF2 und IF1', IF2') in einem niederen Zwischenfrequenzbereich erzeugt werden und die komplexe Filterung eine Phasenverschiebung der zugehörigen In-Phase-Komponenten (I_{IF}, I_{IF'}) und der Quadratur-Komponenten (Q_{IF}, Q_{IF'}) zum zumindest teilweisen Auslöschen der gespiegelten Zwischenfrequenz-Signale (IF1', IF2') durchführt.

17. Verfahren nach Patentanspruch 15 oder 16, **dadurch gekennzeichnet, dass** die Zwischenfrequenz-Signale (IF1, IF2, IF1', IF2') analoge Signale darstellen und eine analoge komplexe Filterung durchgeführt wird.

18. Verfahren nach Patentanspruch 15 oder 16, **dadurch gekennzeichnet, dass** die Zwischenfrequenz-Signale (IF1, IF2, IF1', IF2') digitale Signale darstellen und eine digitale komplexe Filterung durchgeführt wird.

19. Verfahren nach einem der Patentansprüche 16 bis 18, **dadurch gekennzeichnet, dass** bei der RF/IF-Wandlung alle gespiegelten Zwischenfrequenz-Signale (IF1', IF2') im gleichen positiven oder negativen Frequenzbereich liegen.

20. Verfahren nach einem der Patentansprüche 15 bis 19, **dadurch gekennzeichnet, dass** bei der RF/IF-Wandlung eine Vielzahl von LO-Signalen (101, 102, ...) erzeugt werden, die keine Interferenzen zueinander aufweisen.

21. Verfahren nach einem der Patentansprüche 15 bis 20, **dadurch gekennzeichnet, dass** die komplexe Filterung eine Polyphase-Filterung darstellt.

22. Verfahren nach einem der Patentansprüche 15 bis 21, **dadurch gekennzeichnet, dass** bei der Realisierung des RF-Empfangs eine Aufteilung der RF-Signale in ihre zugehörigen Trägerfrequenzbereiche,
eine Verstärkung der RF-Signale in den zugehörigen Trägerfrequenzbereichen, und
ein Zusammenfügen der aufgeteilten und verstärkten RF-Signale durchgeführt wird.

23. Verfahren nach einem der Patentansprüche 15 bis 22, **dadurch gekennzeichnet, dass** bei der Realisierung des RF-Empfangs eine leistungsmäßige Aufteilung der RF-Signale durchgeführt wird.

24. Verfahren nach einem der Patentansprüche 15 bis 23, **dadurch gekennzeichnet, dass** zur Realisierung des IF-Empfangs zumindest eine variable IF-Verstärkung und eine IF-Tiefpass-Filterung durchgeführt wird.

25. Verfahren nach einem der Patentansprüche 15 bis 24, **dadurch gekennzeichnet, dass** bei der digitalen Signalverarbeitung eine Vielzahl von den Zwischenfrequenz-Signalen (IF1, IF2) zugehörigen digitalen Signalkomponenten und eine Tiefpassfilterung der digitalen Signalkomponenten durchgeführt wird.

## Claims

1. Multiband receiver for simultaneous reception of a multiplicity of RF signals, which are at different carrier frequencies, having, an RF receiving part (RF) for processing of the RF signals (RF1, RF2, ...);
an RF/IF converter for conversion of the multiplicity of RF signals (RF1, RF2, ...) to a multiplicity of analog intermediate frequency signals (IF1, IF2);
an IF receiving part (IF) for processing of the intermediate frequency signals;
an A/D converter (13; 13a, 13b) for conversion of the analog intermediate frequency signals to digital intermediate frequency signals; and
a digital signal processing part (DSP) for digital signal processing of the digital intermediate frequency signals and for production of recovered data signals,
**characterized in that**
the RF/IF converter has a multiplicity of local oscillators (LO1, LO2, ...) corresponding to the multiplicity of RF signals (RF1, RF2, ...) for production of LO signals (LO1, LO2, ...) which are associated with the carrier frequencies and have LO in-phase components (I_{LO}) and LO quadrature components (Q_{LO}) as well as an in-phase mixer (10) used for a multiplicity of RF signals and quadrature mixer (9) used for a multiplicity of RF signals for mixing the respective LO in-phase and quadrature components (I_{LO}, Q_{LO}), produced from a multiplicity of local oscillators (LO1, LO2, ...), with the RF signals (RF1, RF2, ...) in order to produce the intermediate frequency signals (IF1, IF2, IF1', IF2') with IF in-phase components (I_{IF}, I_{IF'}) and IF quadrature components (Q_{IF}, Q_{IF'}) in an intermediate frequency band, with a complex filter (AKF; DFK) carrying out complex filtering on the basis of the intermediate frequency signals (IF1, IF2, IF1', IF2') in order to suppress mirror-image intermediate frequency signals.

2. Multiband receiver according to patent claim 1, **characterized in that** the intermediate frequency signals (IF1, IF2 and IF1', IF2') are in a low intermediate frequency band and the complex filter (AKF; DKF) shifts the phase of the associated IF in-phase components (I_{IF}, I_{IF'}) and IF quadrature components (Q_{IF}, Q_{IF'}) in order to at least partially cancel out the mirror-image intermediate frequency signals (IF1', IF2').

3. Multiband receiver according to patent claim 1 or 2, **characterized in that** the intermediate frequency signals (IF1. IF2, IF1', IF2') represent analog signals, and the complex filter is an analog complex filter.

4. Multiband receiver according to patent claim 1 or 2, **characterized in that** the intermediate frequency signals (IF1. IF2, IF1', IF2') represent digital signals, and the complex filter is a digital complex filter.

5. Multiband receiver according to one of patent claims 2 to 4, **characterized in that** the mirror-image intermediate frequency signals (IF1', IF2') all lie in the same positive or negative frequency band.

6. Multiband receiver according to one of patent claims 1 to 5, **characterized in that** the multiplicity of local oscillators (LO1, LO2, ...) produce LO signals (101, 102, ...) which do not interfere with one another.

7. Multiband receiver according to one of patent claims 1 to 6, **characterized in that** the complex filter (AKF; DKF) is a polyphase filter.

8. Multiband receiver according to one of patent claims 1 to 7, **characterized in that** the RF receiving part (RF) has an antenna (1) and a preamplifier.

9. Multiband receiver according to patent claim 8, **characterized in that** the preamplifier has a frequency splitter (2) for splitting the RF signals into their associated carrier frequency bands,
a multiplicity of separate amplifier paths for amplification of the RF signals in the associated carrier frequency bands,
and
a signal combiner (7) for combination of the split and amplified RF signals.

10. Multiband receiver according to patent claim 9, **characterized in that** the amplifier paths each have an RF bandpass filter (3, 4) and a variable RF amplifier (5, 6).

11. Multiband receiver according to one of patent claims 1 to 10, **characterized in that** the RF receiving part has a signal splitter (8) for splitting the RF signals on the basis of power.

12. Multiband receiver according to one of patent claims 1 to 11, **characterized in that** the IF receiving part has at least one IF amplifier path.

13. Multiband receiver according to patent claim 12, **characterized in that** the IF amplifier path has a variable IF amplifier (11; 11a, 11b) and an IF low-pass filter (12; 12a, 12b).

14. Multiband receiver according to one of patent claims 1 to 13, **characterized in that** the digital signal processing part (DSP) has a multiplicity of local oscillators (ΔO1, ΔO2, ...) for production of digital signal components which are associated with the intermediate frequency signals (IF1, IF2, ...), and
a multiplicity of digital low-pass filters (16, 18) for filtering the digital signal components.

15. Method for simultaneous reception of a multiplicity of RF signals, which are at different carrier frequencies, having the following steps:
provision of RF reception for processing of the RF signals (RF1, RF2, ...);
carrying out RF/IF conversion in order to convert the multiplicity of RF signals (RF1, RF2, ...) to a multiplicity of analog intermediate frequency signals (IF1, IF2, ...);
provision of IF reception for processing of the intermediate frequency signals (IF1, IF2, ...);
carrying out A/D conversion in order to convert the analog intermediate frequency signals to digital intermediate frequency signals; and
carrying out digital signal processing of the digital intermediate frequency signals and production of recovered data signals, **characterized in that**,
during the RF/IF conversion process, a multiplicity (corresponding to the multiplicity of RF signals (RF1, RF2, ...)) of LO signals (lo1, lo2, ...) which are associated with the carrier frequencies and have LO in-phase components (I_{LO}) and LO quadrature components (Q_{LO}) are produced, and the LO in-phase and quadrature components (I_{LO}, Q_{LO}) are mixed with the RF signals (RF1. RF2, ...) in order to produce the intermediate frequency signals (IF1. IF2, IF1', IF2') which each have IF in-phase components (I_{IF}, I_{IF'}) and IF quadrature components (Q_{IF}, Q_{IF'}) for the multiplicity of RF signals (RF1, RF2, ...) in an intermediate frequency band, with complex filtering furthermore being carried out on the basis of the intermediate frequency signals (IF1, IF2, IF1', IF2') in order to suppress mirror-image intermediate frequency signals.

16. Method according to patent claim 15, **characterized in that**, during the RF/IF conversion process, intermediate frequency signals (IF1, IF2 and IF1', IF2') are produced in a low intermediate frequency band, and the complex filtering shifts the phase of the associated in-phase components (I_{IF}, I_{IF'}) and quadrature components (Q_{IF}, Q_{IF'}) in order to at least partially cancel out the mirror-image intermediate frequency signals (IF1', IF2').

17. Method according to patent claim 15 or 16, **characterized in that** the intermediate frequency signals (IF1, IF2, IF1', IF2') represent analog signals, and analog complex filtering is carried out.

18. Method according to patent claim 15 or 16, **characterized in that** the intermediate frequency signals (IF1, IF2, IF1', IF2') represent digital signals, and digital complex filtering is carried out.

19. Method according to one of patent claims 16 to 18, **characterized in that**, during the RF/IF conversion process, all the mirror-image intermediate frequency signals (IF1', IF2') lie in the same positive or negative frequency band.

20. Method according to one of patent claims 15 to 19, **characterized in that**, during the RF/IF conversion process, a multiplicity of LO signals (101, 102, ...) are produced which do not interfere with one another.

21. Method according to one of patent claims 15 to 20, **characterized in that** the complex filtering represents polyphase filtering.

22. Method according to one of patent claims 15 to 21, **characterized in that**, during the RF reception process, the RF signals are split into their associated carrier frequency bands, the RF signals are amplified in the associated carrier frequency bands, and the split and amplified RF signals are combined.

23. Method according to one of patent claims 15 to 22, **characterized in that**, during the RF reception process, the RF signals are split on the basis of power.

24. Method according to one of patent claims 15 to 23, **characterized in that** variable IF amplification and IF low-pass filtering are carried out at least once for IF reception.

25. Method according to one of patent claims 15 to 24, **characterized in that**, during the digital signal processing, a multiplicity of digital signal components which are associated with the intermediate frequency signals (IF1, IF2) and the digital signal components are low-pass filtered.

## Revendications

1. Récepteur multibande pour la réception simultanée d'une pluralité de signaux RF avec différentes fréquences porteuses comprenant :
une partie réceptrice RF (RF) pour le traitement des signaux RF (RF1, RF2, ...) ;
un convertisseur RF/IF pour la conversion de la pluralité de signaux RF (RF1, RF2, ...) en une pluralité de signaux de fréquence intermédiaire (IF1, IF2) analogiques ;
une partie réceptrice IF (IF) pour le traitement des signaux de fréquence intermédiaire ;
un convertisseur analogique/numérique (13 ; 13a, 13b) pour la conversion de signaux de fréquence intermédiaire analogiques en signaux de fréquence intermédiaire numériques ; et
une partie de traitement de signal numérique (DSP) pour le traitement de signal numérique des signaux de fréquence intermédiaire numériques et pour générer des signaux de données récupérés,
**caractérisé en ce que**
le convertisseur RF/IF présente une pluralité, correspondant à la pluralité de signaux RF (RF1, RF2, ...), d'oscillateurs locaux (LO1, LO2, ...) pour générer des signaux LO (LO1, LO2, ...) spécifiques aux fréquences porteuses avec des composants en phase LO (I_{LO}) et des composants en quadrature LO (Q_{LO}) ainsi qu'un mélangeur en phase (10) commun à la pluralité de signaux RF et un mélangeur en quadrature (9) commun à la pluralité de signaux RF pour le mélange des composants en phase LO et composants en quadrature (I_{LO}, Q_{LO}) respectifs, qui sont générés à partir de la pluralité d' oscillateurs locaux (LO1, LO2, ...), avec les signaux RF (RF1, RF2, ...) pour générer les signaux de fréquence intermédiaire (IF1, IF2, IF1', IF2') avec des composants en phase IF (I_{IF}, I_{IF'}) et des composants en quadrature IF (Q_{IF}, Q_{IF'}) dans une plage de fréquences intermédiaires,
un filtre complexe (AKF ; DKF) effectuant un filtrage complexe sur la base des signaux de fréquence intermédiaire (IF1, IF2, IF1', IF2') pour la suppression de signaux de fréquence intermédiaire réfléchis.

2. Récepteur multibande selon la revendication 1, **caractérisé en ce que** les signaux de fréquence intermédiaire (IF1, IF2 et IF1', IF2') sont situés dans une basse plage de fréquences intermédiaires et le filtre complexe (AKF ; DKF) effectue un déphasage des composants en phase IF (I_{IF}, I_{IF'}) spécifiques et des composants en quadrature IF (Q_{IF}, Q_{IF'}) pour la suppression au moins partielle des signaux de fréquence intermédiaire (IF1', IF2') réfléchis.

3. Récepteur multibande selon la revendication 1 ou 2, **caractérisé en ce que** les signaux de fréquence intermédiaire (IF1, IF2, IF1', IF2') représentent des signaux analogiques et le filtre complexe est un filtre complexe analogique.

4. Récepteur multibande selon la revendication 1 ou 2, **caractérisé en ce que** les signaux de fréquence intermédiaire (IF1, IF2, IF1', IF2') représentent des signaux numériques et le filtre complexe est un filtre complexe numérique.

5. Récepteur multibande selon l'une quelconque des revendications 2 à 4, **caractérisé en ce que** les signaux de fréquence intermédiaire (IF1', IF2') réfléchis se situent tous dans la même plage de fréquences positives ou négatives.

6. Récepteur multibande selon l'une quelconque des revendications 1 à 5, **caractérisé en ce que** la pluralité d'oscillateurs locaux (LO1, LO2, ...) génèrent des signaux LO (101, 102, ...) qui ne présentent pas d'interférences entre eux.

7. Récepteur multibande selon l'une quelconque des revendications 1 à 6, **caractérisé en ce que** le filtre complexe (AKF ; DKF) présente un filtre polyphasé.

8. Récepteur multibande selon l'une quelconque des revendications 1 à 7, **caractérisé en ce que** la partie réceptrice RF (RF) présente une antenne (1) et un pré-amplificateur.

9. Récepteur multibande selon la revendication 8, **caractérisé en ce que** le pré-amplificateur présente un diviseur de fréquence (2) pour la subdivision des signaux RF entre leurs plages de fréquences porteuses spécifiques,
une pluralité de chemins d'amplificateur séparés pour l'amplification des signaux RF dans les plages de fréquences porteuses spécifiques, et
un combineur de signal (7) pour le guidage commun des signaux RF divisés et amplifiés.

10. Récepteur multibande selon la revendication 9, **caractérisé en ce que** les chemins d'amplificateur présentent chacun un filtre passe-bande RF (3, 4) et un amplificateur RF variable (5, 6).

11. Récepteur multibande selon l'une quelconque des revendications 1 à 10, **caractérisé en ce que** la partie réceptrice RF présente un diviseur de signal (8) pour la subdivision au niveau de la puissance des signaux RF.

12. Récepteur multibande selon l'une quelconque des revendications 1 à 11, **caractérisé en ce que** la partie réceptrice IF présente au moins un chemin d'amplificateur IF.

13. Récepteur multibande selon la revendication 12, **caractérisé en ce que** le chemin d'amplificateur IF présente un amplificateur IF (11 ; 11a, 11b) variable et un filtre passe-bas IF (12 ; 12a, 12b).

14. Récepteur multibande selon l'une quelconque des revendications 1 à 13, **caractérisé en ce que** la partie de traitement de signal numérique (DSP) présente une pluralité d'oscillateurs locaux (ΔO1, ΔO2, ...) pour générer des composants de signal numériques spécifiques aux signaux de fréquence intermédiaire (IF1, IF2, ...), et
une pluralité de filtres passe-bas (16, 18) numériques pour le filtrage des composants de signal numérique.

15. Procédé pour la réception simultanée d'une pluralité de signaux RF avec différentes fréquences porteuses présentant les étapes suivantes :
réalisation d'une réception RF pour le traitement des signaux RF (RF1, RF2, ...) ;
réalisation d'une conversion RF/IF pour la conversion de la pluralité de signaux RF (RF1, RF2, ...) en une pluralité de signaux de fréquence intermédiaire (IF1, IF2, ...) analogiques ;
réalisation d'une réception IF pour le traitement des signaux de fréquence intermédiaire (IF1, IF2, ...) ;
réalisation d'une conversion analogique/numérique pour la conversion des signaux de fréquence intermédiaire analogiques en signaux de fréquence intermédiaire numériques ; et
réalisation d'un traitement de signal numérique des signaux de fréquence intermédiaire numériques et génération de signaux de données récupérés, **caractérisé en ce que**, lors de la conversion RF/IF, une pluralité, correspondant à la pluralité de signaux RF (RF1, RF2, ...), de signaux LO (LO1, LO2, ...) spécifiques aux fréquences porteuses avec des composants en phase LO (I_{LO}) et des composants en quadrature LO (Q_{LO}) est générée et les composants en phase LO et composants en quadrature (I_{LO}, Q_{LO}), sont mélangés avec les signaux RF (RF1, RF2, ...) pour générer les signaux de fréquence intermédiaire (IF1, IF2, IF1', IF2') avec des composants en phase IF (I_{IF}, I_{IF'}) respectifs et des composants en quadrature IF (Q_{IF}, Q_{IF'}) pour la pluralité de signaux RF (RF1, RF2, ...) ensemble dans une plage de fréquences intermédiaires, un filtrage complexe étant effectué également sur la base des signaux de fréquence intermédiaire (IF1, IF2, IF1', IF2') pour la suppression de signaux de fréquence intermédiaire réfléchis.

16. Procédé selon la revendication 15, **caractérisé en ce que**, lors de la conversion RF/IF, des signaux de fréquence intermédiaire (IF1, IF2 et IF1', IF2') sont générés dans une basse plage de fréquences intermédiaires et le filtrage complexe effectue un décalage de phase des composants en phase (I_{IF}, I_{IF'}) spécifiques et des composants en quadrature (Q_{IF}, Q_{IF'}) pour la suppression au moins partielle des signaux de fréquence intermédiaire (IF1', IF2') réfléchis.

17. Procédé selon la revendication 15 ou 16, **caractérisé en ce que** les signaux de fréquence intermédiaire (IF1, IF2, IF1', IF2') représentent des signaux analogiques et un filtrage complexe analogique est effectué.

18. Procédé selon la revendication 15 ou 16, **caractérisé en ce que** les signaux de fréquence intermédiaire (IF1, IF2, IF1', IF2') représentent des signaux numériques et un filtrage complexe numérique est effectué.

19. Procédé selon l'une quelconque des revendications 16 à 18, **caractérisé en ce que**, lors de la conversion RF/IF, tous les signaux de fréquence intermédiaire (IF1', IF2') réfléchis se situent dans la même plage de fréquences positives ou négatives.

20. Procédé selon l'une quelconque des revendications 15 à 19, **caractérisé en ce que**, lors de la conversion RF/IF, une pluralité de signaux LO (LO1, LO2, ...) sont générés, lesquels ne présentent pas d'interférences entre eux.

21. Procédé selon l'une quelconque des revendications 15 à 20, **caractérisé en ce que** le filtrage complexe représente un filtrage polyphasé.

22. Procédé selon l'une quelconque des revendications 15 à 21, **caractérisé en ce que**, lors de la réalisation de la réception RF, on effectue une subdivision des signaux RF entre leurs plages de fréquences porteuses spécifiques,
une amplification des signaux RF dans les plages de fréquence porteuses spécifiques, et
un assemblage des signaux RF subdivisés et amplifiés.

23. Procédé selon l'une quelconque des revendications 15 à 22, **caractérisé en ce que**, lors de la réalisation de la réception RF, on effectue une subdivision au niveau de la puissance de signaux RF.

24. Procédé selon l'une quelconque des revendications 15 à 23, **caractérisé en ce que**, pour la réalisation de la réception RF, on effectue au mois une amplification RF variable et un filtrage avec un filtre passe-bas IF.

25. Procédé selon l'une quelconque des revendications 15 à 24, **caractérisé en ce que**, lors du traitement de signal numérique, on utilise une pluralité de composants de signal numériques spécifiques aux signaux de fréquence intermédiaire (IF1, IF2) et un filtrage avec un filtre passe-bas des composants de signal numériques.
